# EUROPÄISCHE PATENTSCHRIFT

(11) **EP 0 692 741 B1**
(45) Veröffentlichungstag und Bekanntmachung des Hinweises auf die Patenterteilung: **02.04.1997**
(21) Anmeldenummer: 94110982.9
(22) Anmeldetag: 14.07.1994
(51) Int. Cl.: G03F 7/20, B41C 1/14

(54) **Vorrichtung zur Herstellung einer Siebdruckschablone**
Device for making a printing screen
Dispositif de fabrication pour écran sérigraphique

(43) Veröffentlichungstag der Anmeldung: 17.01.1996
(73) Patentinhaber: Schablonentechnik Kufstein Aktiengesellschaft, A-6330 Kufstein (AT)
(72) Erfinder: Hörfarter, Siegfried Ing., A-6344 Walchsee (AT)
(74) Vertreter: TER MEER - MÜLLER - STEINMEISTER & PARTNER

(56) Entgegenhaltungen:
- EP-A- 0 562 149
- DE-A- 2 634 841
- US-A- 3 664 737
- US-A- 3 696 742
- US-A- 4 553 822
- PATENT ABSTRACTS OF JAPAN vol. 11, no. 74 (M-568) (2521) 6. März 1987 & JP-A-61 229 560 (RICOH CO LTD) 13. Oktober 1986

## Beschreibung

Die Erfindung betrifft eine Vorrichtung zur Herstellung einer Siebdruckschablone gemäß dem Oberbegriff des Patentanspruchs 1, mit einer Lichtquelle zur Aussendung eines Lichtbündels, dessen Fokus im Bereich einer auf einem Schablonensieb vorhandenen lichtempfindlichen Schicht liegt, und mit einer Einrichtung zur Erzeugung einer Relativbewegung zwischen Lichtbündel und Schablonensieb, wobei das Lichtbündel in Übereinstimmung mit einem gewünschten Schablonenmuster auf die lichtempfindliche Schicht auftrifft, das Lichtbündel wenigstens in einem Abschnitt linear polarisiert ist, in diesem Abschnitt ein elektrooptischer Modulator zur Drehung der Schwingungsebene des Lichtbündels angeordnet ist, im Lichtweg hinter dem elektrooptischen Modulator ein Analysator liegt, und der elektrooptische Modulator die Schwingungsebene des Lichtbündels in Übereinstimmung mit empfangenen Schablonenmusterdaten dreht.

Aus der US-A-3,664,737 ist bereits eine Vorrichtung bekannt, die sich zur Herstellung einer Siebdruckschablone eignet. Sie enthält eine Lichtquelle zur Aussendung eines Lichtbündels, das linear polarisiert wird, und dessen Fokus im Bereich einer auf einem Zylinder vorhandenen lichtempfindlichen Schicht liegt, wobei das Lichtbündel in Übereinstimmung mit einem Muster auf die lichtempfindliche Schicht auftrifft. Ein elektrooptischer Modulator mit einem Analysator ist im polarisierten Lichtbündel angeordnet, um die Schwingungsebene des Lichtbündels zu drehen. Diese Drehung erfolgt in Übereinstimmung mit den empfangenen Musterdaten.

Es ist in den letzten 10 Jahren üblich geworden, anstelle der früher gebräuchlichen Großfilmtechnik ein Musterbild, z.B. durch entsprechend angesteuerte Laser in geeigneter Weise auf die Druckform zu übertragen. Zum Beispiel kann eine metallische, gelochte Hülse mit Kunstharz überzogen werden und dieses an den Stellen mit Laserstrahlung abgetragen werden, an welchen die Schablone für Druckfarbstoff durchlässig werden soll. Hierzu wird üblicherweise eine langwellige Laserstrahlung von etwa 10,6 µm Wellenlänge verwendet und ein CO₂-Laser, welcher eine solche Strahlung emittiert, wird synchron zu den Erfordernissen des Musterbildes elektrisch angeregt (EP 0 562 149 A1).

Auch der umgekehrte Fall wurde vorgeschlagen, bei welchem eine nur vorgetrocknete aber noch nicht polymerisierte (also vernetzte) Lackschicht durch Einwirkung von Laserstrahlung vernetzt wird. Zur Vernetzung ist es im allgemeinen erforderlich, eine kurzwellige Strahlung zu verwenden, die vorzugsweise im nahen UV-Bereich liegt. Es ist heute möglich, bis zu einer Wellenlänge von etwa 555 nm Polymerisationswirkungen in Kunstharzen zu erreichen, wobei dann allerdings Photosensibilisatoren den Harzen beigemischt werden müssen (EP 0 593 806 A1).

Der Erfindung liegt die Aufgabe zugrunde, die Vorrichtung der eingangs genannten Art so weiterzubilden, daß sich mit ihr noch schärfere Schablonenmuster herstellen lassen.

Die Lösung der gestellten Aufgabe ist im kennzeichnenden Teil des Patentanspruchs 1 angegeben. Vorteilhafte Ausgestaltungen der Erfindung sind den Unteransprüchen zu entnehmen.

Eine Vorrichtung nach der Erfindung zur Herstellung einer Siebdruckschablone zeichnet sich dadurch aus, daß der Analysator im Falle der Lichtsperrung des Lichtbündels auf eine Leistungsmeßzelle koppelt, und daß die für den Lichtdurchtritt erforderliche und vom elektrooptischen Modulator vorgenommene Drehung der Schwingungsebene des Lichtbündels in Abhängigkeit eines Ausgangssignals der Leistungsmeßzelle nachgestellt wird.

Die Schablonenmusterdaten dienen zur Ansteuerung des elektrooptischen Modulators. Liegen Schablonenmusterdaten vor, die sich auf einen Bereich beziehen, der später für die Druckfarbe durchlässig sein soll, wird bei einer einfachen Harzschicht die Schwingungsebene des Lichtbündels durch den elektrooptischen Modulator so gedreht, daß das Lichtbündel den nachfolgenden Analysator passieren kann. Die Harzschicht wird somit durch das fokussierte Lichtbündel in diesem Bereich abgetragen. Bei einer zu polymerisierenden Lackschicht wird für denselben Bereich bzw. dieselben Musterdaten die Schwingungsebene des Lichtbündels durch den elektrooptischen Modulator so gedreht, daß der nachfolgende Analysator das Lichtbündel unterbricht. Dieser Bereich wird somit nicht vernetzt und kann später durch geeignete Entwicklung der Schicht abgetragen werden. Dagegen gelten für diejenigen Bereiche der Siebdruckschablone, die später für die Druckfarbe undurchlässig sein sollen, die entgegengesetzten Verhältnisse.

Es hat sich gezeigt, daß durch die Kombination der obigen Maßnahmen Schablonenmuster mit scharfer Kantenstruktur bzw. sehr genauen Gravurkanten entstehen, auch wenn Oberflächengeschwindigkeiten von rotierenden Metallsieben gewählt werden, die im Bereich ≧ 2 m/s, maximal bei 12 bis 13 m/s, liegen. So wird einerseits durch das innerhalb eines Musterbereichs kontinuierlich eingeschaltete Lichtbündel eine einwandfreie Energiestabilisierung erzielt, so daß beim Abschalten des Lichtbündels am Rand der Musterstruktur die Energie immer von ihrem maximalen Wert abfällt, was zu einem abrupten Energieübergang und damit zu einer scharfen Kantenstruktur führt. Darüber hinaus sorgen die Abschaltzeiten, die infolge des elektrooptischen Modulators im Bereich von ns liegen können, andererseits für einen äußerst raschen Abfall der Energie des Lichtbündels, wodurch sich auch bei hohen Rotationsgeschwindigkeiten keine sich nachteilig auswirkenden Strukturverwischungen ergeben können.

Als wesentlich hat sich herausgestellt, den Analysator im Falle der Lichtsperrung des Lichtbündels auf eine Leistungsmeßzelle herauszukoppeln, wobei die für den Lichtdurchtritt erforderliche und vom elektrooptischen Modulator vorgenommene Drehung der Schwingungsebene des Lichtbündels in Abhängigkeit eines Ausgangssignals der Leistungsmeßzelle nachgestellt wird. Während der Unterbrechung des Lichtbündels wird also die Intensität der Lichtquelle gemessen, um im Falle einer Intensitätsänderung für den nachfolgenden Einschaltzyklus des Lichtbündels die Schwingungsebene des Lichtbündels durch den elektrooptischen Modulator so zu verändern, daß das eingeschaltete Lichtbündel über den gesamten Gravurvorgang immer eine konstante Intensität aufweist. Um genügend Spielraum zu höheren und niedrigeren Intensitäten zu haben, wird die an den elektrooptischen Modulator angelegte Hochspannung so voreingestellt, daß die Schwingungsebene des Lichtbündels im Durchlaßfall sich nicht vollständig mit der Durchlaßrichtung des Analysators deckt.

Polarisator und Analysator können z. B. durch Doppelprismen gebildet sein. Nach einer anderen Ausgestaltung der Erfindung kommt als Lichtquelle ein ein linear polarisiertes Lichtbündel aussendender Laser zum Einsatz. Dieser kann vorzugsweise ein diodengepumpter Nd-Yag-Laser sein, wenn es sich z. B. um zu polymerisierende Lackschichten auf dem Schablonensieb handelt.

Nach einer vorteilhaften Ausgestaltung der Erfindung befindet sich im linear polarisierten Abschnitt des Lichtbündels vor dem elektrooptischen Modulator ein Polarisator, dem eine Baueinheit folgt, die gegenüber dem Polarisator die Schwingungsebene des Lichtbündels um 45° dreht. Entgegen derAusbreitungsrichtung des Lichtbündels verlaufende Strahlung, z. B. erzeugt durch Reflexion am Metallsieb der Schablone, kann somit nicht mehr zur Lichtquelle gelangen und diese nachteilig beeinflussen, da diese rückreflektierte Strahlung jetzt aus dem Strahlengang herausgekoppelt wird und z. B. in einen Strahlfänger gelangt. Die genannte Baueinheit kann z. B. ein Faraday-Rotator sein, dessen Aufbau allgemein bekannt ist und zur Drehung der Schwingungsebene des Lichtbündels von einem Magnetfeld Gebrauch macht.

Andererseits kann der elektrooptische Modulator eine Pockels-Zelle oder eine Kerr-Zelle sein und durch geeignete Hochspannung angesteuert werden, die zur Drehung der Schwingungsebene des Lichtbündels in Abhängigkeit der bereits genannten Musterdaten angelegt wird.

Die Erfindung wird nachfolgend unter Bezugnahme auf die Zeichnung näher beschrieben. Es zeigen:
- **Fig. 1**: eine schematische Gesamtansicht einer Laser-Gravurvorrichtung, und
- **Fig. 2**: den genaueren Aufbau des in Fig. 1 verwendeten Lasers.

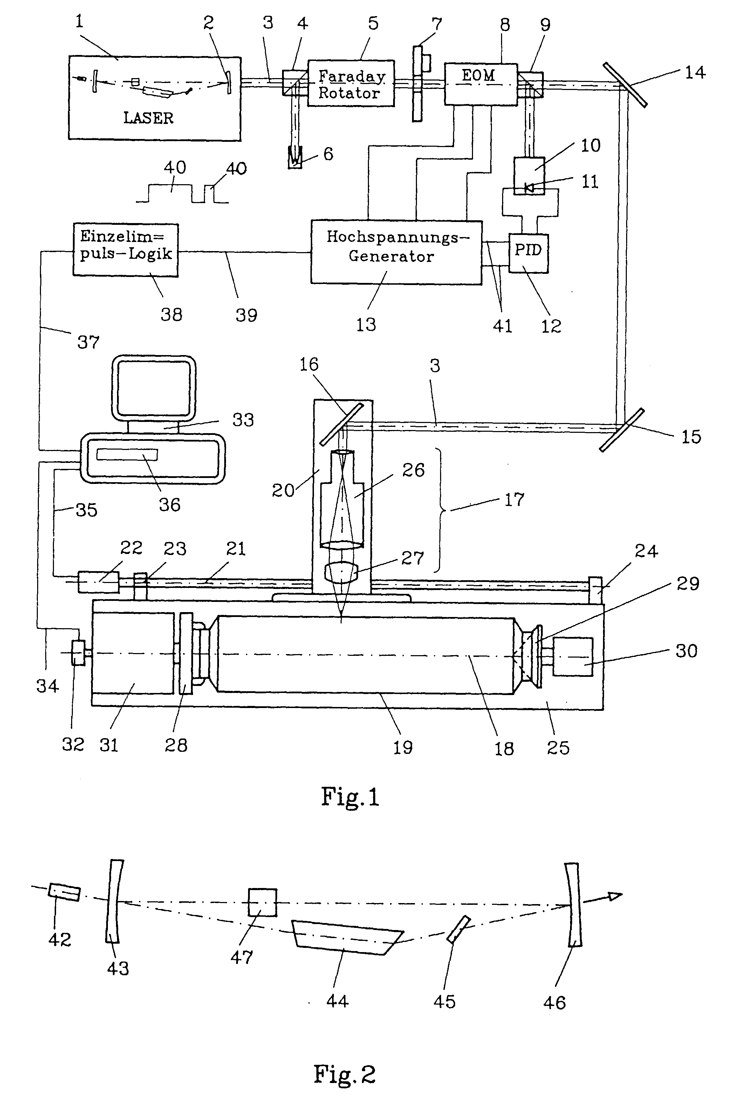

Der Aufbau der erfindungsgemäßen Vorrichtung ist in Fig. 1 schematisch dargestellt. Sie enthält einen Laser 1, der durch ein Austrittsfenster 2 hindurch einen linear polarisierten Laserstrahl 3 emittiert. Die Wellenlänge des Laserstrahls 3 kann im Bereich von 500 von 540 nm liegen. Beispielsweise kann als Laser 1 ein Argon-Ionenlaser zum Einsatz kommen, dessen Strahlung eine Wellenlänge von 514 nm aufweist. Es kann aber auch ein Yag-Neodym-Laser verwendet werden mit einer Strahlungswellenlänge im Ausgangsbereich von 10,6 µm, die dann auf 532 nm herabgesetzt werden kann.

Ein erster Polarisator 4, der aus zwei Nicolschen Prismen besteht, läßt den Laserstrahl 3 mit nahezu gar keinen Verlusten hindurchtreten, da die Durchlaßrichtung des Polarisator 4 mit der Polarisationsrichtung des Laserstrahls 3 übereinstimmt. Ein in Strahlrichtung hinter dem Polarisator 4 angeordneter Faraday-Rotator 5 dreht nun die Polarisationsrichtung des Laserstrahls 4 um 45 ° um dessen Längsachse. Entgegen der Ausbreitungsrichtung des Laserstrahls 3 und z.B. durch Reflexion erzeugte Strahlung gelangt erneut in den Faraday-Rotator 5, so daß dort deren Polarisationsebene wiederum um 45 ° gedreht wird, was dazu führt, daß jetzt die Polarisationsebene der reflektierten Strahlung um 90 ° relativ zur Durchlaßrichtung des Polarisators 4 verdreht ist und durch diesen aus dem Strahlengang ausgekoppelt wird, um in einem Strahlfänger 6 absorbiert zu werden. Auf diese Weise wird das Betriebsverhalten des Lasers 1 stabilisiert, da in ihn keine reflektierte Strahlung mehr hineingekoppelt werden kann.

Hinter dem Faraday-Rotator 5 kann im Strahlengang des Laserstrahls 3 ein Shutter 7 liegen, der in Not- oder Sonderfällen den Laserstrahl 3 unterbricht.

Anschließend ist im Strahlengang des Laserstrahls 3 ein elektrooptischer Modulator (EOM) 8 angeordnet. Dieser elektrooptische Modulator 8 kann z.B. eine Kerr-Zelle oder eine Pockels-Zelle sein. Je nach Spannungsbeaufschlagung wird durch ihn die Lage der Polarisationsebene des Laserstrahls 3 um weitere 90 ° gedreht oder nicht gedreht. Dem elektrooptischen Modulators 8 folgt im Strahlengang des Laserstrahls 3 ein Analysator 9, der ebenfalls aus zwei Nicolschen Prismen aufgebaut ist. Der Analysator 9 hat die Aufgabe, den Laserstrahl 3, wenn dieser nicht auf eine Siebdruckschablone fallen soll und daher vom elektrooptischen Modulator 8 um 90 ° gedreht wurde, aus dem Strahlengang auszukoppeln. Soll dagegen der Laserstrahl 3 auf die Siebdruckschablone auftreffen, würde dessen Polarisationsebene durch den elektrooptischen Modulator 8 nicht gedreht, so daß jetzt der Laserstrahl 3 den Analysator 9 durchlaufen kann.

Für den Fall der Auskopplung des Laserstrahls 3 durch den Analysator 9 trifft der Laserstrahl 3 auf eine Leistungsmeßzelle 10, die zu diesen Zeiten die effektive Strahlleistung ermittelt. Zu diesem Zweck befindet sich im Innern der Leistungsmeßzelle 10 eine Meßdiode 11. Diese Meßdiode 11 ist mit einem PID-Regler 12 verbunden, der seinerseits von der gemessenen Strahlleistung abhängige Ausgangssignale zu einem Hochspannungsgenerator 13 liefert, welcher die erforderliche Hochspannung zwecks Drehung der Polarisationsebene des Laserstrahls 3 zum elektrooptischen Modulator 8 gibt. Durch den PID-Regler 12 wird für den nachfolgenden Durchlaßzustand des Analysators 9 eine Feinregelung der für den elektrooptischen Modulator 8 vorgesehenen Hochspannung zur Strahlungsleistungseinstellung durchgeführt, deren Aufgabe es ist, durch entsprechende Rückdrehung der Polarisationsebene des Laserstrahls 3 den Maximalwert der Strahlungsleistung auf einen konstanten Betrag einzustellen.

Wird die Polarisationsrichtung des Laserstrahls 3 im elektrooptischen Modulator 8 nicht oder nur wenig gedreht, kann der Laserstrahl 3 mit geringfügigen Verlusten den Analysator 9 passieren. Jetzt wird der Laserstrahl 3 über Umlenkspiegel 14, 15 und 16 zu einer Optik 17 geleitet, die in Richtung der Zentralachse 18 der Siebdruckschablone 19 auf einem Schlitten 20 bewegbar ist. Der Schlitten 20 wird über eine Spindel 21 verschoben, wobei die Spindel 21 mittels eines Gleichstrommotors (Schrittmotors) 22 gedreht wird. Die Spindel 21 ist über Halterungen 23, 24 an einem Maschinenbett 25 befestigt. Die Optik 17 besteht im wesentlichen aus einem Strahlaufweiter 26 und einer Fokussierlinse 27. Die Strahlaufweitung ist vorgesehen, um nach der Fokussierung des Laserstrahls 3 auf den Mantel der Siebdruckschablone 19 durch die Fokussierlinse 13 einen möglichst kleinen Fokusdurchmesser zu erhalten.

Die Siebdruckschablone 19 ist drehbar auf dem Maschinenbett 25 einer Gravurmaschine gelagert und wird von einem Spannfutter 28 linksseitig gehalten und auf der rechten Seite von einem Stützkegel 29 getragen. Der Stützkegel 29 ist in einem Reitstock 30 ebenfalls drehbar gelagert. Dabei kann der Reitstock 30 in Längsrichtung der Zentralachse 18 auf dem Maschinenbett 25 verschoben werden, um dessen Position an unterschiedliche Längen der Siebdruckschablone 19 anpassen zu können. Über das Spannfutter 28 wird der Siebdruckschablone 19 eine gleichförmige Rotationsbewegung erteilt, wobei das Spannfutter 28 in einem Spindelstock 31 gelagert ist. Ein Encoder 32 auf der Welle des Spannfutters 28 meldet einem zentralen Steuerungsrechner 33 die jeweilige Drehlage der Siebdruckschablone 19 über eine Leitung 43. Ein weiterer Encoder im Inneren des Gleichstrommotors 22 meldet die Längsposition des Schlittens 22 mit der darauf darauf befindlichen Optik 17 über eine weitere Leitung 35 ebenfalls zum zentralen Steuerungsrechner 33. Unter Verwendung dieser Eingangsinformationen und aufgrund der in einem elektronischen Speicher 36 abgespeicherten Musterinformation ist der zentrale Steuerungsrechner 33 in der Lage, die notwendige Strahlsteuerungsinformation (= Impulszüge) über eine Steuersignalleitung 37 an eine Einzelimpulslogik 38 abzugeben. Diese Einzelimpulslogik 38 gibt dann Einzelimpulse mehr oder weniger großer Länge über eine Signalleitung 39 zum bereits erwähnten Hochspannungsgenerator 13. Die Einzelimpulse tragen das Bezugszeichen 40 und bilden ein Gravursignal. Der Hochspannungsgenerator 13 gibt dabei seine Hochspannung nur dann an den elektrooptischen Modulator 8 ab, wenn er über die Signalleitung 39 entsprechende Gravursignale 40 empfängt. Diese Hochspannung wird, wie bereits erwähnt, durch Einstellsignale vom PID-Regler 12 beeinflußt, die zum Hochspannungsgenerator 13 über Signalleitungen 41 gelangen. Diese zuletzt genannten Einstellsignale verändern die vom Hochspannungsgenerator 13 an den elektrooptischen Modulator 8 abgegebene Hochspannung nur geringfügig, und zwar nur in jenem Ausmaß, wie dies für die Aufrechterhaltung einer konstanten optischen Strahlleistung des Laserstrahls 3 notwendig ist. Es sei darauf hingewiesen, daß die Einstellung der Strahlleistung nur für die Zeiten erfolgt, in denen der Laserstrahl 3 durch den Analysator 9 hindurchgeht. Während dieser Durchlaßzeiten, in denen der Laserstrahl 3 zur Siebdruckschablone gelangt, erfolgt keine Strahlleistungsmessung. Zu diesen Zeiten sinkt der Wert der Strahlleistung im Bereich der Leistungsmeßzelle 10 unterhalb eines vorbestimmten Pegels, so daß der PID-Regler 12 deaktiviert wird.

Die Fig. 2 zeigt den genaueren Aufbau des Lasers 1, der in diesem Fall ein diodengepumpter Nd-Yag-Laser ist. Eine Halbleiterlaserdiode 42 emittiert Strahlung mit einer Wellenlänge von 700 bis 800 nm. Diese tritt durch den für Strahlung dieser Wellenlänge durchlässigen Endspiegel 43 in das Innere des Resonators. In diesem befindet sich der Nd-Yag-Stab (Glas oder Kristall) 44, der zum Lasern angeregt wird. Die Laserstrahlung tritt aus der rechten Endfläche dieses Stabes 44 unter dem typischen Brechungswinkel aus und durchläuft eine Brewsterplatte 45. Letztere stellt sicher, daß nur linear polarisierte Strahlung im Laser entsteht. Vom rechten und für Strahlung von 532 nm teildurchlässigen Endspiegel 46 (Austrittsfenster 2 in Figur 1) wird die 1065 nm Laserstrahlung, die vom Stab 44 imitiert wird, reflektiert und durchläuft einen NLO-Kristall 47 (NLO = Nichtlineare Optik), der einen Prozentsatz der 1065 nm Strahlung in 532 nm Strahlung zufolge nichtlinearer optischer Effekte umsetzt. Sowohl die Strahlung mit 532 nm als auch jene mit 1065 nm werden dann vom linken Endspiegel 33 des Resonators wieder reflektiert und der beschriebene Zyklus beginnt von neuem. Bei dem rechten Endfenster 46 wird kontinuierlich Strahlung mit 532 nm Wellenlänge ausgekoppelt. Durch die Anordnung des NLO-Kristalls 47 innerhalb des Resonators liegt der Kristall immer in einem Bereich hoher Strahlenergie und arbeitet mit gutem Wirkungsgrad.

## Patentansprüche

1. Vorrichtung zur Herstellung einer Siebdruckschablone, mit einer Lichtquelle (1) zur Aussendung eines Lichtbündels (3), dessen Fokus im Bereich einer auf einem Schablonensieb (19) vorhandenen lichtempfindlichen Schicht liegt, und mit einer Einrichtung zur Erzeugung einer Relativbewegung zwischen Lichtbündel (3) und Schablonensieb (19), wobei das Lichtbündel (3) in Übereinstimmung mit einem gewünschten Schablonenmuster auf die lichtempfindliche Schicht auftrifft,
das Lichtbündel (3) wenigstens in einem Abschnitt linear polarisiert ist,
in diesem Abschnitt ein elektrooptischer Modulator (8) zur Drehung der Schwingungsebene des Lichtbündels (3) angeordnet ist,
im Lichtweg hinter dem elektrooptischen Modulator (8) ein Analysator (9) liegt, und
der elektrooptische Modulator (8) die Schwingungsebene des Lichtbündels (3) in Übereinstimmung mit empfangenen Schablonenmusterdaten dreht, **dadurch gekennzeichnet**, daß der Analysator (9) im Falle der Lichtsperrung das Lichtbündel (3) auf eine Leistungsmeßzelle (10) koppelt, und daß die für den Lichtdurchtritt erforderliche und vom elektrooptischen Modulator (8) vorgenommene Drehung der Schwingungsebene des Lichtbündels (3) in Abhängigkeit eines Ausgangssignals der Leistungsmeßzelle (10) nachgestellt wird.

2. Vorrichtung nach Anspruch 1, **dadurch gekennzeichnet,** daß im linear polarisierten Abschnitt des Lichtbündels (3) vor dem elektrooptischen Modulator (8) ein Polarisator (4) liegt, dem eine Baueinheit (5) folgt, die gegenüber dem Polarisator (4) die Schwingungsebene des Lichtbündels (3) um 45 ° dreht.

3. Vorrichtung nach Anspruch 2, **dadurch gekennzeichnet,** daß die Baueinheit (5) ein Faraday-Rotator ist.

4. Vorrichtung nach Anspruch 1, 2 oder 3, **dadurch gekennzeichnet,** daß der elektrooptische Modulator (8) eine Pockels-Zelle oder eine Kerr-Zelle ist.

5. Vorrichtung nach einem der Ansprüche 1 bis 4, **dadurch gekennzeichnet,** daß der Polarisator (4) von der Baueinheit (5) kommende Strahlung in einen Leistungsfänger (6) koppelt.

6. Vorrichtung nach einem der Ansprüche 1 bis 5, **dadurch gekennzeichnet,** daß der Polarisator (4) und der Analysator (9) durch Doppelprismen gebildet sind.

7. Vorrichtung nach einem der Ansprüche 1 bis 6, **dadurch gekennzeichnet,** daß die Lichtquelle (1) ein ein linear polarisiertes Lichtbündel (3) aussendender Laser ist.

8. Vorrichtung nach Anspruch 7, **dadurch gekennzeichnet,** daß der Laser (1) ein diodengepumpter Nd-Yag-Laser ist.

## Claims

1. Device for producing a screen printing stencil, having a light source (1) for emitting a bundle of light (3) whose focus lies in the region of a light-sensitive layer present on a stencil screen (19), and having an apparatus for generating a relative movement between the bundle of light (3) and screen stencil (19), the bundle of light (3) being incident on the light-sensitive layer in accordance with a desired stencil pattern, the bundle of light (3) being linearly polarized in at least one section,
there being arranged in this section an electrooptical modulator (8) for rotating the plane of oscillation of the bundle of light (3),
there being an analyser (9) in the light path downstream of the electrooptical modulator (8), and
the electrooptical modulator (8) rotating the plane of oscillation of the bundle of light (3) in accordance with received stencil pattern data, **characterized in that,** when the light is blocked, the analyser (9) couples the bundle of light (3) to a power measuring cell (10), and in that the rotation, of the plane of oscillation of the bundle of light (3), which is necessary for the passage of the light and which is carried out by the electroooptical modulator (8) is adjusted as a function of an output signal of the power measuring cell (10).

2. Device according to Claim 1, **characterized in that,** in the linearly polarized section of the bundle of light (3), upstream of the electrooptical modulator (8), there is a polarizer (4) which is followed by a unit (5) which rotates the plane of oscillation of the bundle of light (3) by 45° with respect to the polarizer (4).

3. Device according to Claim 2, **characterized in that** the unit (5) is a Faraday rotator.

4. Device according to Claim 1, 2 or 3, **characterized in that** the electrooptical modulator (8) is a Pockels cell or a Kerr cell.

5. Device according to one of Claims 1 to 4, **characterized in that** the polarizer (4) couples radiation coming from the unit (5) into a dummy load (6).

6. Device according to one of Claims 1 to 5, **characterized in that** the polarizer (4) and the analyser (9) are formed by double prisms.

7. Device according to one of Claims 1 to 6, **characterized in that** the light source (1) is a laser emitting a linearly polarized bundle of light (3).

8. Device according to Claim 7, **characterized in that** the laser (1) is a diode-pumped Nd-Yag laser.

## Revendications

1. Dispositif de fabrication d'un écran d'impression sérigraphique, avec une source lumineuse (1) destinée à émettre un faisceau lumineux (3), dont le foyer est situé dans la zone d'une couche photosensible existant sur un écran sérigraphique (19) et avec un organe de génération d'un déplacement relatif entre le faisceau lumineux (3) et l'écran sérigraphique (19), dans lequel le faisceau lumineux (3) vient frapper la couche photosensible en correspondance avec un modèle d'écran souhaité,
le faisceau lumineux (3) est polarisé de façon linéaire au moins sur un tronçon,
un modulateur électro-optique (3) est disposé dans un tronçon pour assurer la rotation du plan de vibration du faisceau lumineux (3),
un analyseur (9) est placé sur le trajet suivi par la lumière, derrière le modulateur électro-optique (8), et le modulateur électro-optique fait tourner le plan de vibration du faisceau lumineux (3) en correspondance avec les données de modèle d'écran reçues, caractérisé en ce que l'analyseur (9), dans le cas d'un blocage de la lumière, accouple le faisceau lumineux (3) à une cellule de mesure de puissance (10) et en ce que la rotation nécessaire pour le passage de la lumière et effectuée par le modulateur électro-optique (8), du plan de vibration du faisceau lumineux (3), est réglée à nouveau en fonction d'un signal de sortie de la cellule de mesure de puissance (10).

2. Dispositif selon la revendication 1, caractérisé en ce qu'un polariseur (4) est placé devant le modulateur électro-optique (8) dans le tronçon à polarisation linéaire du faisceau lumineux (3), et est suivi par un composant (5) qui effectue une rotation de 45° du plan de vibration du faisceau lumineux (3) par rapport au polariseur (4).

3. Dispositif selon la revendication 2, caractérisé en ce que le composant (5) est un rotateur de Faraday.

4. Dispositif selon la revendication 1, 2 ou 3, caractérisé en ce que le modulateur électro-optique (8) est une cellule de Pockels ou bien une cellule de Kerr.

5. Dispositif selon l'une des revendications 1 à 4, caractérisé en ce que le polariseur (4) assure le couplage dans un récepteur de puissance (6) du rayonnement venant du composant (5).

6. Dispositif selon l'une des revendications 1 à 5, caractérisé en ce que le polariseur (4) et l'analyseur (9) sont constitués par des prismes doubles.

7. Dispositif selon l'une des revendications 1 à 6, caractérisé en ce que la source lumineuse (1) est un laser émettant un faisceau lumineux (3) à polarisation linéaire.

8. Dispositif selon la revendication 7, caractérisé en ce que le laser (1) est un laser Nd-Yag à pompage par diode.
